# EUROPEAN PATENT APPLICATION

(11) **EP 3 410 384 A1**
(43) Date of publication of application: **05.12.2018**
(21) Application number: 17174257.0
(22) Date of filing: 02.06.2017
(51) Int. Cl.: G06Q 50/04, G06Q 10/04, G06Q 10/06

(54) **A METHOD AND SYSTEM FOR OPTIMIZING MEASURES WITHIN A VALUE CHAIN OF AN INVESTIGATED SYSTEM**

(71) Applicant: Siemens Aktiengesellschaft, 80333 München (DE)
(72) Inventor: Höfig, Kai, 80797 München (DE)

(57) **Abstract**

An optimization system (1) configured to perform a continuous optimization of a value chain (VC) of an investigated manufactured system (6), wherein in each stage (VCS) of said value chain (VC) items related to the investigated system (6) comprise associated sets of failure modes, fm, with corresponding measures, m, wherein each failure mode, fm, refers to a global system effect, e, of the investigated system (6), wherein each stage (VCS) of the value chain (VC) of the investigated system (6) is adapted to report separately its measures, m, effectiveness values, ev₁, and effort values, ev₂, to update a global FMEA data model using a meta model, MM, wherein the optimization system (1) comprises a calculation unit (2) configured to perform a global failure mode effect, FMEA, analysis of the investigated system (6) for its entire value chain (VC) using the updated global FMEA data model to generate an optimized set, M, of measures, m.

## Description

The invention relates to a method and system for optimizing measures within a value chain of an investigated system using a model-based failure mode effect analysis (FMEA).

A value chain of an investigated system typically comprises different value chain stages or phases including a design stage, a production stage and an operation stage. During these different phases or stages, failure mode effect analysis (FMEA) can deductively investigate the different items of the different phases. The items of the different phases or stages of the value chain differ widely.

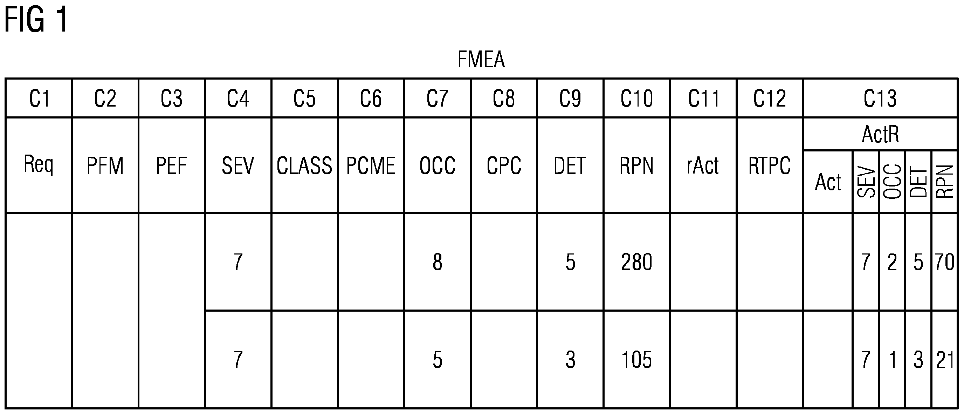

Fig. 1 shows an example of a conventional FMECA analysis (failure mode effect and criticality analysis) used for analyzing a complex system. As illustrated in Fig. 1, the illustrated table comprises several columns c (c1 to c13). The first column c1 comprises the requirements and indicate the requirements of an item to be analyzed. For instance, the requirement can be the application of wax inside a door. The manual application of the wax can be used to cover an inner door, a lower surface at minimum wax thickness to retard corrosion of the component.

The next column c2 indicates a potential failure mode PFM. The potential failure mode is for instance insufficient wax coverage over a specified surface. The potential failure mode in general specifies what can happen to the item to be analyzed.

The next column c3 indicates a potential effect of failure PEF. The column Potential Effect of Failure is used to describe the effect. In the specific example, a potential effect of failure may indicate a deteriorated life of door leading to
unsatisfactory appearance due to rust through paint over time and
impaired function of interior door hardware.

The next column c4 comprises a severity number indicating a severeness of the effect. The column c4 SEV is used to assign a numeric value referring to a severity of the failure effect. For example, the more severe the effect is, the higher the severity number. For example, one can agree on a scale where 1 signifies nearly no effect and 10 signifies severe injuries of a person. Column c5 can comprise a class.

The next column cc indicates potential causes/mechanisms of failure PCMF. The column Potential Causes/Mechanisms of Failure PCMF is used to document the causes of failures. In the specific example, causes of failure may include that a manually inserted spray head has not been inserted far enough or that the spray heads became clogged due to either too high viscosity or too low temperature or too low pressure.

In the next column c7 OCC is a numeric value which is used to document occurrence of the failure. For example, one can use a scale where 1 means that the failure is nearly impossible and 10 for failures that typically occur within 24 operating hours of the investigated system. In the illustrated example, a first cause in column c6 can get an occurrence value of 8 whereas the second cause in column c6 gets an associated occurrence value of 5.

The next column c8 indicates current process controls CPC. The column Current Process Controls is used to document measures that are currently installed. In the specific example, a first measure installed is a visual check each hour for a film thickness (depth meter) and coverage. The second measure associated to the second potential cause of failure is to test a spray pattern at start-up and after idle periods and to perform preventive maintenance programs to clean these spray heads.

In the next column c9, the value DET is indicated used to document a detectability of failure effects.

The next column c10 indicates a risk priority number RPN. The risk priority number RPN can be calculated as the product of the parameters OCC (column c7), severity SEV (column c4) and detectability DET (column c9).

The next column c11 indicates recommended actions rAct. The column Recommended Actions is used to document actions that can mitigate or prevent the effect of the failure mode. In the specific example, the recommended actions may include to add positive depth stop to sprayer, to provide automated spraying and/or to use design of experiments (DOE) on viscosity versus temperature versus pressure.

In the next column c12, the column responsibility and target completion date RTCD is indicated. The column Responsibility and Target Completion Date is used to set a deadline for the respective action. In the illustrated example, a first recommended action has the deadline or completion date 15.10.1998, the second recommended action RA2 has the completion date 15.12.1998 and the third recommendation RA3 has the completion date 1.10.1998. All actions are in the responsibility of the engineering department.

In the next column c13, action results ActR are indicated. Action results ActR include the actions taken and they include severity occurrence and detectability as well as the calculated risk priority number RPN. The column Action Results, Actions Taken can be used to document the actions actually taken and the column action results, SEV, action results OCC, action results DET and action results, RPN can be used to assign new values for the parameters occurrence, detectability and controllability with the new action in place to calculate a reduced risk priority number RPN'. In the illustrated specific example, the actions taken may include added stop and sprayer checked on line as well as rejection due to complexity of different doors on the same line and determination of temperature and pressure limits and installation of limit controls with corresponding severity occurrence and detectability values. In the specific example of the table as illustrated in Fig. 1, the first risk priority number RPN1 can be reduced by the actions taken from 280 to 70. Further, the second risk priority number RPN2 is reduced from 105 to 21.

From the example shown in Fig. 1, it can be seen that the conventional FMEA analysis has several drawbacks. Failure modes resulting in the same effect cannot be addressed adequately to optimize the measures taken to prevent the failure. Further, different measures that aim at different phases or stages of a value chain can have different costs and effectiveness values. For instance, in operation, a measure m can be human interaction, while in the design phase a measure can comprise automated testing. Optimizing the measures according to the impact on different failure modes (reuse of measures to prevent more than one failure mode) is impossible since they cannot be addressed adequately in a manually maintained table as shown in Fig. 1. Further, automated reconfiguration of the value chain does not result in an automated adoption of the failure mode analysis.

Accordingly, it is an object of the present invention which allows to optimize measures within a value chain of an investigated system comprising several value chain stages.

This object is achieved according to a first aspect of the present invention by a method for optimizing measures within a value chain of an investigated system comprising the features of claim 1.

The invention provides according to the first aspect of the present invention, a method for optimizing measures within a value chain of an investigated system,
wherein in each stage of said value chain items related to the investigated system comprise associated sets of failure modes with corresponding measures, wherein each failure mode refers to a global system effect of the investigated system, wherein each stage of the value chain reports separately its measures, effectiveness values and effort values for performing a global failure mode effect analysis of the investigated system for the entire value chain of the investigated system using an FMEA meta model stored in a global database.

In a possible embodiment of the method according to the first aspect of the present invention, the value chain of the investigated system is optimized automatically at runtime of the investigated system.

In a further possible embodiment of the method according to the first aspect of the present invention, the value chain of the investigated system comprises a design stage and/or a production stage and/or an operation stage.

In a further possible embodiment of the method according to the first aspect of the present invention, global system effects are predicted in the design stage, predicted and/or measured during the production stage and measured during the operation stage of the investigated system.

In a further possible embodiment of the method according to the first aspect of the present invention, the investigated system comprises a final manufactured product designed in a design stage, manufactured in a production stage and operated during an operation stage of the value chain.

In a further possible embodiment of the method according to the first aspect of the present invention, on the basis of each detected global system effect of the investigated system the FMEA meta model stored in the global database is used to trace backwards through a network of dependencies of failure modes and measures to optimize the applied sets of measures and/or failure modes.

In a further possible embodiment of the method according to the first aspect of the present invention, the items related to the investigated system comprise
in the design stage of the value chain, data elements representing hardware components and/or software components of the investigated system,
in the production stage of the value chain, production steps and/or production facilities to manufacture the investigated system, and
in the operation stage of the value chain, physical hardware components and/or implemented software components of the investigated system.

In a further possible embodiment of the method according to the first aspect of the present invention, the measures of the different value chain stages comprise associated measure parameters.

In a further possible embodiment of the method according to the first aspect of the present invention, the measures of the design stage of the value chain of the investigated system comprise design test measures, fault removal measures, redesign measures, and/or redundancy implementation measures.

In a further possible embodiment of the method according to the first aspect of the present invention, the measures of the production stage of the value chain of the investigated system comprise production quality measures, measurement measures, and/or production test measures.

In a still further possible embodiment of the method according to the first aspect of the present invention, the measures of the operation stage of the value chain of the investigated system comprise interaction measures, maintenance and/or repair measures, redesign measures and/or software update measures.

The invention further provides according to a further aspect an optimization system comprising the features of claim 10.

The invention provides according to the second aspect of the present invention an optimization system configured to perform a continuous optimization of a value chain of an investigated manufactured system,
wherein in each stage of the value chain items related to the investigated system comprise associated sets of failure modes with corresponding measures wherein each failure mode refers to a global system effect of the investigated system, wherein each stage of the value chain of the investigated system is adapted to report separately its measures, effectiveness values and effort values to update a global FMEA data model using a metamodel,
wherein the optimization system comprises
a calculation unit configured to perform a global failure mode effect, FMEA, analysis of the investigated system for its entire value chain using the updated global FMEA data model to generate an optimized set of measures.

In a possible embodiment of the optimization system according to the second aspect of the present invention, the value chain of the investigated system comprises different value chain stages including a design stage and/or a production stage and/or an operation stage.

In a further possible embodiment of the optimization system according to the second aspect of the present invention, the investigated system comprises a final manufactured product designed in a design stage, manufactured in a production stage and operated during an operation stage of the value chain.

In a further possible embodiment of the optimization system according to the second aspect of the present invention, the FMEA meta model stored in the global database is used on the basis of each detected global system effect of the investigated system to trace backwards through a network of dependencies of failure modes and measures to optimize the applied sets of measures and/or failure modes.

In a still further possible embodiment of the optimization system according to the second aspect of the present invention, the calculation unit comprises communication interfaces to receive measures, effectiveness values, effort values and/or measure parameters reported by value chain stages of the value chain of the investigated system to calculate automatically and iteratively an optimized set of measures for the different value chain stages of the investigated system.

In a further possible embodiment of the optimization system according to the second aspect of the present invention, the calculation unit is configured to perform the global failure mode effect, FMEA, analysis of the investigated system for its entire value chain using the updated global FMEA data model in response to input global optimization criteria for the investigated system.

In the following, possible embodiments of the different aspects of the present invention are described in more detail with reference to the enclosed figures.
- Fig. 1: shows schematically an FMEA table used in a conventional analysis for illustrating a problem underlying the present invention;
- Fig. 2: shows a block diagram for illustrating a possible exemplary embodiment of an optimization system according to an aspect of the present invention;
- Fig. 3: illustrates schematically a meta model used by the method and system according to the present invention for optimizing measures within a value chain of an investigated system;
- Fig. 4: shows schematically the implementation of a value chain FMEA for different value chain stages to illustrate the operation of a method and system for optimizing measures within a value chain of an investigated system according to the present invention;
- Fig. 5: shows schematically an exemplary implementation of an investigated system which can be optimized by an optimization system according to an aspect of the present invention.

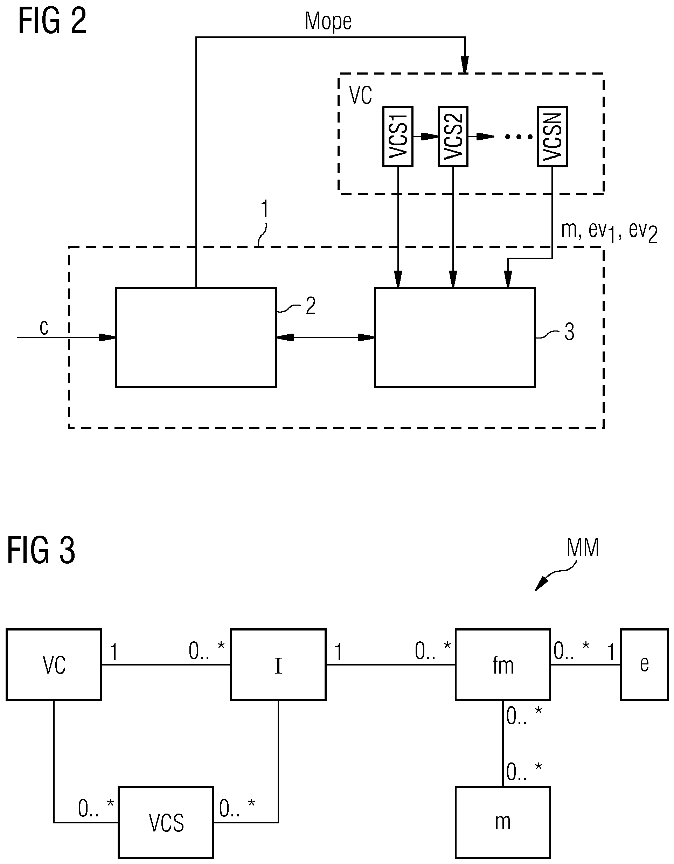

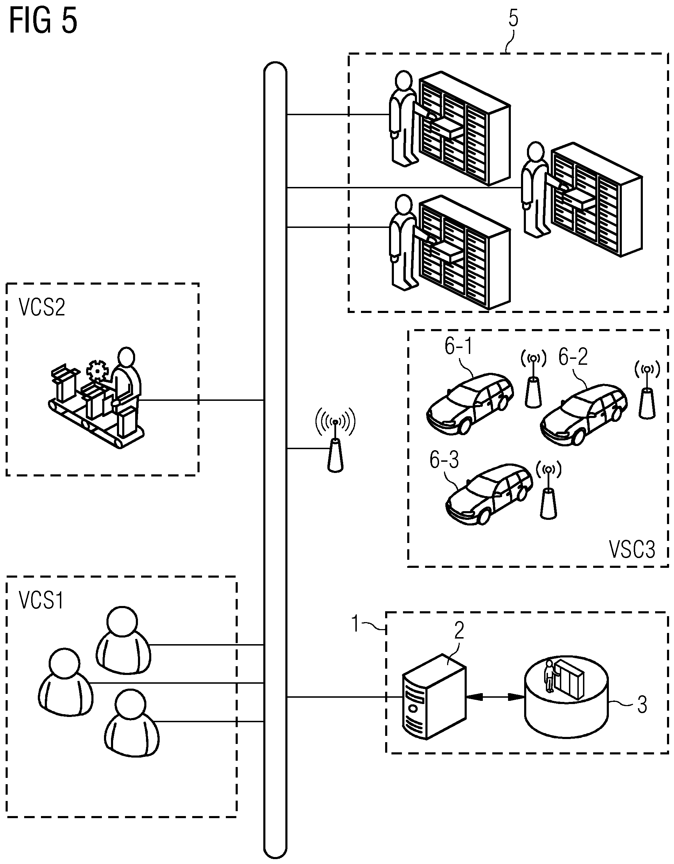

As can be seen in Fig. 2, an optimization system 1 comprises in the illustrated exemplary embodiment a calculation unit 2 having access to a global database 3. The optimization system 1 is configured to perform a continuous optimization of a value chain VC of an investigated manufactured system 6. An example of an investigated system 6 is a vehicle or car produced in a factory and monitored during operation as shown in Fig. 5. The investigated manufactured system 6 can comprise a final manufactured product such as a car or wind turbine forming a complex technical system with different subsystems and a plurality of components. These components can include software components as well as hardware components. For example, a wind turbine as a complex system to be investigated by the optimization system 1 can comprise as subsystems a gearbox and a generator. The investigated system 6 such as a wind turbine or car can include different value chain stages VCS or phases of a value chain VC. The investigated system 6 can comprise as a value chain VC for instance a value chain including a design stage, a production stage and an operation stage. In general, the value chain VC of the investigated system 6 can comprise N value chain stages VCS as illustrated in Fig. 2. The optimization system 1 is configured to perform a continuous optimization of the value chain VC of the investigated manufactured system 6. In each value chain VCS of the value chain VC, items related to the investigated system 6 comprise associated sets of failure modes fm with corresponding measures m, wherein each failure mode fm refers to a global system effect e of the investigated system 6.

As illustrated in Fig. 2, each value chain stage VCS of the value chain VC of the investigated system 6 is adapted to report separately its measures m, effective values and effort values to update a global FMEA data model stored in the global database 3 using a meta model MM.

The calculation unit 2 of the optimization system 1 is configured to perform a global failure mode effect, FMEA, analysis of the investigated system 6 for its entire value chain VC using the updated global FMEA data model to generate an optimized set M of measures m. On the basis of each detected global system effect e of the investigated system 6, the FMEA meta model stored in the global database 3 of the optimization system 1 is used to trace backwards through a network of dependencies of failure modes fm and measures m to optimize the applied set of measures m and/or failure modes fm. In a possible embodiment, the calculation unit 2 of the optimization system 1 comprises a communication interface to receive measures m, effectiveness values ev₁, effort values ev₂ and/or measure parameters reported by the different value chain stages VCS of the value chain VC of the investigated system 6 to calculate automatically and iteratively an optimized set Mₒₚₜ of measures m for the different value chain stages VCS of the investigated system 6. The optimized set Mₒₚₜ of measures m are applied to the different value chain stages VCS of the investigated system 6 as illustrated in Fig. 2. In a possible embodiment, the calculation unit 2 of the optimization system 1 is configured to perform a global failure mode effect, FMEA, analysis of the investigated system 6 for its entire value chain VC using the updated global FMEA data model stored in the global database 3 in response to input global optimization criteria c for the investigated system 6. Accordingly, the calculation unit 2 may comprise an interface to receive optimization criteria c. The calculation unit 2 may further be adapted to receive a set of parameters from the investigated system 6. The global optimization criteria c can for instance relate to a design time, a production time or an operation time of the investigated system 6 as well as for instance to the number of implemented elements or components in the investigated system 6. For instance, the optimization may require that the investigated system 6 comprises an operation lifetime of at least ten years (optimization criterion for the operation stage of the investigated system), that the manufactured system 6 may be produced within a production time of four weeks (optimization criterion for a production stage of the investigated system) and that the number of implemented components or elements shall be less than 2000 components (optimization criterion for the design stage). Accordingly, the optimization criteria c may refer to different value chain stages VCS or phases of the value chain VC of the investigated system 6. The global optimization criteria c may be input by a user via an user interface of the optimization system 1. Further, selected optimization criteria c can be downloaded from a database 3.

In a possible embodiment, the value chain VC of the investigated system is optimized using the set Mₒₚₜ of optimized measures m automatically at runtime of the investigated system 6. In a possible embodiment, the value chain VC of the investigated manufactured system 6 can comprise a design stage, a production stage and an operation stage. In the design stage, global system effects e can be predicted. In the production stage, global system effects e can be either measured or predicted. Further, during the operation stage of the investigated system 6, global system effects e can be measured. On the basis of the detected global system effects e of the investigated system, the FMEA meta model stored in the global database 3 can be used to trace backwards through a network of dependencies of failure modes fm and measures m to optimize the applied sets of measures and/or failure modes.

In each stage VCS of the value chain VC, items I related to the investigated system 6 such as a wind turbine comprise associated sets of failure modes with corresponding measures, wherein each failure mode refers to a global system effect e of the investigated system 6. The items I related to the investigated system 6 comprise in the design stage of the value chain VC data elements representing hardware components and/or software components of the investigated system 6. The data elements can comprise for instance text documents, requirement specifications, certificates or any other kind of electronic documents representing a hardware component and/or a software component of the investigated system 6.

The items I related to the investigated system 6 comprise in the production stage of the value chain VC production steps and/or production facilities to manufacture the investigated system 6.

Further, the items I related to the investigated system 6 comprise in an operation stage of the value chain VC physical hardware components and/or implemented software components of the manufactured investigated system 6.

The measures m of the different value chain stages VCS can comprise associated measure parameters.

The measures m of the design stage of the value chain VC of the investigated system 6 can for instance comprise design test measures, fault removal measures, redesign measures and/or redundancy implementation measures.

Further, the measures m of a production stage of the value chain VC of the investigated system 6 can for instance comprise production quality measures, measurement measures, production test measures.

Further, the measures of an operation stage of the value chain VC of the investigated system 6 can comprise for instance interaction measures, maintenance and/or repair measures, redesign measures and/or software update measures.

As illustrated in Fig. 2, each value chain stage VCS of the value chain VC can report separately via associated interfaces measures m as well as effectiveness values ev₁ and/or effort values ev₂ and feed them to the global database 3 of the optimization system 1. Further, associated measure parameters of the measures m can be supplied by the value chain stages VCS to the global database 3. Interfaces between the value chain stages VCSi can comprise wireless and/or wired interfaces. Accordingly, the global database 3 of the optimization system 1 is continuously updated with the measures m, effectiveness values ev₁ and effort values ev₂ as well as parameters from the different value chain stages VCS of the value chain VC of the investigated system 6. The optimization system 1 allows a structured analysis of different phases of the value chain VC to increase the quality of the investigated system 6 by an optimal set Mₒₚₜ of measures m.

Fig. 3 shows schematically a meta model MM used by the method and system according to the present invention. The meta model MM as illustrated in Fig. 3 can be stored in the global database 3 of the optimization system 1.

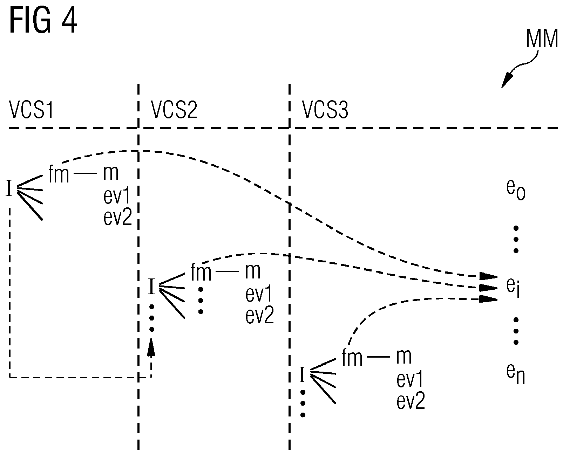

Fig. 4 shows an exemplary implementation of the meta model MM as depicted in Fig. 3. As can be seen in Fig. 4, different phases of a value chain VC of the investigated system 6 can be addressed. In the illustrated example, a value chain VC of the investigated system 6 comprises three different phases or stages VCS1, VCS2, VCS3. The first value chain stage VCS1 can comprise a design stage of the investigated system 6. The second value chain stage VCS2 can comprise a production stage of the manufactured investigated system. The third value chain stage VCS3 can comprise an operation phase of the investigated system 6. In each stage of the value chain VC, there are different items I to be analyzed of the manufactured system 6 being produced. Each item I can have a certain set of failure modes fm for the respective phase. Each failure mode fm can have a measure m with additional parameters. Further, each measure m can have associated effectiveness values ev₁ and/or effort values ev₂. The effort values ev₂ can for instance comprise required costs.

As illustrated in Fig. 4, each failure mode fm can result in a system-wide global effect e that is not related to a certain phase or stage VCS but becomes visible at the execution time of the investigated system 6, for instance at the operation phase which is typically the last phase or stage VCS of the analyzed system 6 under investigation.

During a design phase VCS1, the items I can comprise data elements of the investigated system 6 representing hardware and/or software components of the system. These items I can be electronic data representations, building blocks, software functions. These items can be analyzed for the failure modes (options to fail) and their associated system-wide effect e.

During production VCS2, elements of a process form a transformation process from inputs to final products. The steps of production and their failures can influence the final manufactured product or system under investigation and therefore have an influence on the final manufactured system 6. Measures m uncovering failures or prevention mechanisms can typically consist of process industry quality measures, such as tolerance value checking and removal of defective products from the production.

During operation VCS3 of the manufactured system 6 or product, failures can occur during the operation of the product. Typically maintenance and/or repair activities are provided to prevent unwanted system effects e.

As illustrated in Fig. 4, each failure mode fm can result in a system-wide global effect e being not related to a certain value chain stage VCS but only becoming visible in a final stage of the value chain VC. Additionally, some items I of previous phases or stages can be uncovered or detected by quality measures m of later value chain stages VCS. As can be seen in Fig. 4, a failure mode fm of an item I being analyzed in the design stage (VCS1) can be addressed by a measure m of the production stage (VCS2) and by a measure m of the operation stage (VCS3).

Having an effect e globally in place, allows to trace backwards through the network of dependencies of failure modes fm and measures m. In this way, failure modes fm that are addressed by multiple measures m can be optimized, e.g. by looking for the most effective and cheapest measure m in the whole value chain VC. With a conventional separate analysis for each stage, this global optimization is impossible. When the data is maintained using the meta model MM addressing the entire value chain VC of the investigated system 6, global optimization to provide a set Mₒₚₜ of optimal measures m becomes possible. The measures m can comprise in general measures which are performed manually but also measures which can be performed automatically. The measure m including a manual task can for instance comprise a maintenance activity of an operator in the operation stage VCS3. Automatic measures m can include for instance automated measurements of threshold values during a production process in the production stage VCS2. The digital meta model MM enables to optimize a production process of an investigated system 6 at runtime according to the costs for better measures and according to the impact of an optimal measure taking the other measures of different other stages VCS into account.

Fig. 3 illustrates an embodiment of the meta model MM used by the optimization system 1 according to the present invention. As illustrated in Fig. 3, the stored meta model MM indicates that the value chain VC consists of different value chain stages VCS. Each item I of the value chain VC can be relevant in different phases or value chain stages VCS. Further, each item I refers to a different set of failure modes fm. Each failure mode fm can have different measures m, either in the same phase or in different phases. Further, each failure mode fm refers to one global system effect e of the system under investigation.

Fig. 5 shows an example of a complex system which can be investigated and optimized by an optimization system 1 according to an aspect of the present invention. The optimization system 1 comprises a calculation unit 2 and a global FMEA database 3. It can be connected via a communication channel 4 to different stages VCS of a value chain VC of an investigated system 6 such as a vehicle. The manufactured system or product 6 is in the illustrated example of Fig. 5 a car or a vehicle. The investigated product is designed in a design stage VCS1, produced in a production stage VCS2 and operated in a traffic system in an operation stage VCS3 as shown in Fig. 5. The optimization system 1 can be connected in the illustrated exemplary implementation via a communication channel 4 to the different value chain stages VCS1, VCS2, VCS3 as well as to further databases storing additional information and data about the investigated system 6. In the illustrated example, the additional database 5 can for instance store maintenance data referring to the manufactured products 6-1, 6-2, 6-3 illustrated in Fig. 5. In the illustrated example, the manufactured product or system 6 under investigation is a mobile product such as a car. In an alternative embodiment, the manufactured product 6 can also comprise a product placed at a fixed location such as a wind turbine. In the illustrated implementation of Fig. 5, the mobile manufactured products, e.g. cars, can communicate via access points with the optimization system 1. The mobile manufactured products or systems 6 under investigation can in this way supply during operation information data via the access point AP and the communication channel 4 to the optimization system 1 where the received data can be used for updating the content of the global FMEA database stored in the memory 3. Each stage VCS of the value chain VC, including the design stage VCS1, the production stage VCS2 as well as the operation stage VCS3, can report in a separate communication channel its measures m, effectiveness values ev₁ and effort values ev₂ to the optimization system 1 for performing a global failure mode effect, FMEA, analysis of the investigated system 6, e.g. the designed and produced car, for the entire value chain VC of the investigated system 6 using the FMEA meta model MM stored in the global database 3 as illustrated in Fig. 3. Each stage VCS can separately report for instance about their costs for different quality measures m and their effectiveness ev₁. These field data can be put into the value chain failure mode and effect analysis. Using the meta model MM stored in the global database 3, the optimization system 1 can automatically decide what is an optimal set Mₒₚₜ of measures m based on the impact on global effects e. An outcome of such an analysis may be that measures m in the production need to be extended or be more precise to decrease the number of critical effects during an operation phase of the investigated system 6. Alternatively, other measures m may be applied in the design stage to optimize the value chain VC by a decreased number of maintenance activities.

Another example for an investigated system 6 is a wind turbine. A wind turbine can comprise as essential subsystems a gearbox and a generator. An example of quality measures in a design phase of a generator of a wind turbine include software testing and electric emergency shutdown functionality in case of a load drop. During a production phase of such items, in a gearbox, sophisticated quality measures such as hardened surfaces are relatively cost-intensive, but are highly effective to prevent failure modes of gearwheels such as flaking of surface elements.

During an operation phase, gearbox oil can be changed on a scheduled base as a measure m to prevent the failure mode fm of overheating the gearbox. Two important global effects e of a wind turbine that need to be prevented are an emergency stop and free rotation. The emergency stop is related to all the failure modes fm that can be detected during the operation phase and sets the wind turbine in this stage to prevent further damage, such as a load drop. Other failure modes fm cannot be detected and end up in a free rotation of the wind turbine, such as a software failure in the emergency shutdown mechanism.

If during a value chain VC of such a wind turbine forming an investigated system 6 all relevant parameters such as hardening of the gearwheels, measuring of the hardening process and test, type of software tests, software integration test, test of the emergency shutdown procedure as well as operation measures such as oil change of the gearbox are stored in the global database 3 and using the predefined FMEA meta model, the optimization system 1 can decide whether for a given average operation time of the wind turbine 6, the measure m of hardened surfaces is sufficient to fulfil the operation requirement. Vice versa, if the failure mode fm of a load drop is a negligible rare event (e.g. due to other prevention measures in the power grid), the optimization mechanism can decide to remove the detection measure for a power drop from the value chain VC to optimize the costs or it can foresee that a different surface hardening is sufficient enough to meet the operation parameters. Various complex sets M of measures can be evaluated against each other until an optimal solution is found. If the operation of all parameters change, e.g. due to a climate change, the value chain VC can be reevaluated automatically to provide a safe design, production and optimal operational costs of the investigated system 6.

## Claims

1. A method for optimizing measures within a value chain (VC) of an investigated system (6),
wherein in each stage (VCS) of said value chain (VC) items related to the investigated system (6) comprise associated sets of failure modes, fm, with corresponding measures, m, wherein each failure mode, fm, refers to a global system effect, e, of the investigated system (6),
wherein each stage of the value chain (VC) reports separately its measures, m, effectiveness values, ev₁, and effort values, ev₂, for performing a global failure mode effect, FMEA, analysis of the investigated system (6) for the entire value chain (VC) of the investigated system (6) using an FMEA meta model, MM, stored in a global database (3).

2. The method according to claim 1 wherein the value chain of the investigated system (6) is optimized automatically at runtime of the investigated system (6).

3. The method according to claim 1 or 2 wherein the value chain of the investigated system (6) comprises a design stage (VCS1) and/or
a production stage (VCS2) and/or
an operation stage (VCS3).

4. The method according to claim 3 wherein global system effects, e, are predicted in the design stage (VCS1), predicted and/or measured during the production stage (VCS2) and measured during the operation stage (VCS3) of the investigated system (6).

5. The method according to any of the preceding claims 1 to 4 wherein the investigated system (6) comprises a final manufactured product designed in a design stage,
manufactured in a production stage and operated during an operation stage of the value chain.

6. The method according to any of the preceding claims 1 to 5 wherein on the basis of each detected global system effect, e, of the investigated system (6) the FMEA meta model stored in the global database (3) is used to trace backwards through a network of dependencies of failure modes, fm, and measures, m, to optimize the applied sets of measures, m, and/or failure modes.

7. The method according to any of the preceding claims 1 to 6 wherein the items related to the investigated system (6) comprise
in the design stage of the value chain data elements representing hardware components and/or software components of the investigated system (6),
in the production stage of the value chain production steps and/or production facilities to manufacture the investigated system (6), and
in the operation stage of the value chain physical hardware components and/or implemented software components of the investigated system (6).

8. The method according to any of the preceding claims 1 to 7 wherein the measures, m, of the different value chain stages (VCS) comprise associated measure parameters.

9. The method according to any of the preceding claims 1 to 8 wherein the measures, m, of the design stage (VCS1) of the value chain (VC) of the investigated system (6) comprise design test measures,
fault removal measures,
redesign measures,
redundancy implementation measures,
wherein the measures, m, of the production stage (VCS2) of the value chain (VC) of the investigated system (6) comprise production quality measures,
measurement measures,
production test measures,
wherein the measures, m, of the operation stage (VCS3) of the value chain (VC) of the investigated system (6) comprise interaction measures,
maintenance and/or repair measures,
redesign measures and/or
software update measures.

10. An optimization system (1) configured to perform a continuous optimization of a value chain (VC) of an investigated manufactured system (6),
wherein in each stage (VCS) of said value chain (VC) items related to the investigated system (6) comprise associated sets of failure modes, fm, with corresponding measures, m, wherein each failure mode, fm, refers to a global system effect, e, of the investigated system (6),
wherein each stage (VCS) of the value chain (VC) of the investigated system (6) is adapted to report separately its measures, m, effectiveness values, ev₁, and effort values, ev₂, to update a global FMEA data model using a meta model, MM,
wherein the optimization system (1) comprises a calculation unit (2) configured to perform a global failure mode effect, FMEA, analysis of the investigated system (6) for its entire value chain (VC) using the updated global FMEA data model to generate an optimized set, M, of measures, m.

11. The optimization system according to claim 10 wherein the value chain (VC) of the investigated system (6) comprises different value chain stages (VCS) including
a design stage (VCS1) and/or
a production stage (VCS2) and/or
an operation stage (VCS3).

12. The optimization system according to claim 10 or 11
wherein the investigated system (6) comprises a final manufactured product designed in a design stage,
manufactured in a production stage and operated during an operation stage of the value chain (VC).

13. The optimization system according to any of the preceding claims 10 to 12 wherein on the basis of each detected global system effect, e, of the investigated system (6), the FMEA meta model, MM, stored in the global database (3) is used to trace backwards through a network of dependencies of failure modes, fm, and measures, m, to optimize the applied sets of measures, m, and/or failure modes.

14. The optimization system according to any of the preceding claims 10 to 13 wherein the calculation unit (2) comprises communication interfaces to receive measures, m, effectiveness values, ev₁, effort values, ev₂, and/or measure parameters reported by value chain stages (VCS) of the value chain (VC) of the investigated system (6) to calculate automatically and iteratively an optimized set, Mₒₚₜ, of measures, m, for the different value chain stages (VCS) of the investigated system (6).

15. The optimization system according to any of the preceding claims 10 to 14 wherein the calculation unit (2) is configured to perform the global failure mode effect, FMEA, analysis of the investigated system (6) for its entire value chain (VC) using the updated global FMEA data model in response to input global optimization criteria, c, for the investigated system (6).
